Europäisches Patentamt

European Patent Office

Office européen des brevets

(11) Publication number: **0 506 052 A1**

## EUROPEAN PATENT APPLICATION

(21) Application number: **92105225.4**

(22) Date of filing: **26.03.92**

(51) Int. Cl.[5]: **H01L 21/22**, C01B 31/36

(30) Priority: **28.03.91 JP 89673/91**

(43) Date of publication of application:
**30.09.92 Bulletin  92/40**

(84) Designated Contracting States:
**DE FR GB**

(71) Applicant: **SHIN-ETSU CHEMICAL CO., LTD.**
**6-1, Ohtemachi 2-chome**
**Chiyoda-ku Tokyo(JP)**

(72) Inventor: **Matsumoto, Fukuzi**
**1-5, Kitago 2-chome**
**Takefu-shi, Fukui-ken(JP)**
Inventor: **Hayashi, Michio**
**23-26, Hachiman 1-chome**
**Takefu-shi, Fukui-ken(JP)**
Inventor: **Hamaya, Noriaki**
**1-9, Kitano-cho 1-chome**
**Sabae-shi, Fukui-ken(JP)**

(74) Representative: **TER MEER - MÜLLER -**
**STEINMEISTER & PARTNER**
**Mauerkircherstrasse 45**
**W-8000 München 80(DE)**

(54) **Silicon carbide jig.**

(57) Rod and plate-shaped members of sintered silicon carbide are ground on the surface, assembled and jointed into a jig. The jig has high dimensional precision and is resistant against failure by thermal stresses and shocks. It is a useful jig for use in semiconductor diffusion furnaces.

**FIG.1**

Rank Xerox (UK) Business Services

This invention relates to a silicon carbide jig for use in a diffusion or oxidation furnace for the heat treatment of semiconductor wafers. More particularly, it relates to a silicon carbide jig finished to high dimensional precision and having enough strength to prevent failure by thermal stresses and shocks. The present invention also relates to a method of preparing the same.

Most conventional jigs for use in semiconductor diffusion furnaces are of quartz because of high purity. Quartz jigs, however, suffer from a short lifetime since they can be deformed at high temperatures. The recent diffusion furnace tends toward automatic operation including wafer loading, insertion, positioning, and withdrawal, which requires jigs of high dimensional precision. Since quartz jigs are prone to deformation according to circumstances, they cannot be used over 3 or 4 batches. This causes to increase the manufacturing cost.

Silicon carbide jigs are sometimes available. In the prior art, silicon carbide jigs are fabricated by furnishing pre-sintered members, assembling and jointing the members to form a cage structure, and sintering and sand blasting the structure. Alternatively, jigs are fabricated by sand blasting sintered members on the surface, assembling and jointing the members, and subjecting the assembly to blasting again. However, conventional silicon carbide jigs are poorer in thermal impact and stress than the quartz jigs and liable to damage during use. Particularly since the recent semiconductor manufacturing technology tends toward larger diameter wafers and larger quantity heat treatment, the heat capacity of wafers and associated jigs which are inserted from room temperature into furnaces heated at high temperatures is increased. Therefore, higher thermal stresses occur in the jigs upon insertion and heating. Another recent attempt to reduce the heat treatment time for more efficient manufacture favors more rapid heating and cooling steps. This also causes the silicon carbide jigs to experience rigorous thermal shocks. Thus the silicon carbide jigs see the higher frequency of failure in the current situation. Semiconductor manufacturers expect the development of higher strength silicon carbide jigs.

One approach is a jig having slit plates as shown in Japanese Patent Application Kokai No. 217622/1988. This structure is not satisfactory in strength.

The jigs for use in semiconductor diffusion furnaces are required to have a dimensional precision of micron order particularly when they are used in an automatic process as previously mentioned. In manufacturing prior art silicon carbide jigs, they are subject to substantial deformation during sintering and jointing steps, which deformation causes a loss of productivity. In order that such jigs have high dimensional precision, sintered members must be subject to some finishing steps which will substantially increase the manufacturing cost.

Therefore, an object of the present invention is to provide a silicon carbide jig which is finished to high dimensional precision and has enough strength to prevent failure by thermal stresses and shocks. Another object of the present invention is to provide a method of preparing such a silicon carbide jig.

The inventors have found that bar or plate-shaped members of sintered silicon carbide are machined or ground on the surface and then assembled and joined into a silicon carbide jig which is finished to high dimensional precision and has enough strength to prevent failure by thermal stresses and shocks.

According to the present invention, there is provided a silicon carbide jig comprising a plurality of sintered silicon carbide members having a machined or ground surface, the members being assembled and jointed into the jig.

The present invention also provides a method of preparing a silicon carbide jig comprising
machining or grinding the surface of a plurality of sintered silicon carbide members, and
assembling and jointing the members into the jig.
FIG. 1 is a perspective view of a jig according to one embodiment of the invention.
FIG. 2 is an enlarged cross sectional view of a section X in FIG. 1.
FIG. 3 is an enlarged cross sectional view of a section Y in FIG. 1.
FIG. 4 illustrates how to measure the dimensional precision of members.

According to the present invention, a silicon carbide jig is constructed by machining shaped members of sintered silicon carbide, assembling them into a desired structure, and jointing them at their connections.

The sintered silicon carbide members may be of bar shape including cylindrical rods and columns or of plate shape including flat plates and disks. Often bar and plate shaped members are used in combination to construct a structure. The sintered silicon carbide body may be any of reaction sintered silicon carbide, recrystallized silicon carbide, and atmospheric pressure sintered silicon carbide and the like although the reaction sintered silicon carbide and recrystallized silicon carbide are preferred for semiconductor-related members.

The sintered silicon carbide members may be machined or ground by a conventional grinding machine such as a surface grinder and cylindrical grinder, preferably using an abrasive wheel having a grain size of #60 or finer, especially #60 to #240, more especially #120 to #240. Abrasive wheels coarser than #60 would detract from the strength of silicon carbide members whereas abrasive wheels finer than #240 provide an extremely slow grinding speed which increases the machining cost. The silicon carbide members are ground to such a degree that the maximum surface roughness Rmax is up to 15 $\mu$m, especially up to 12 $\mu$m (Rmax is the maximum height of surface irregularities according to JIS B 0601). The members would lose some strength if Rmax is beyond 15 $\mu$m. Often diamond wheels are used although other commonly used grinding wheels such as borozone and GC wheels are acceptable.

A binder is used for fixedly joining bar or plate shaped members. Useful binders include silicon carbide powder, graphite powder, and silicon powder in admixture with resins such as phenol resins, furan resins, silicone resins and the like. Joints can be completed by heating to a temperature of 1,420 to 1,500°C.

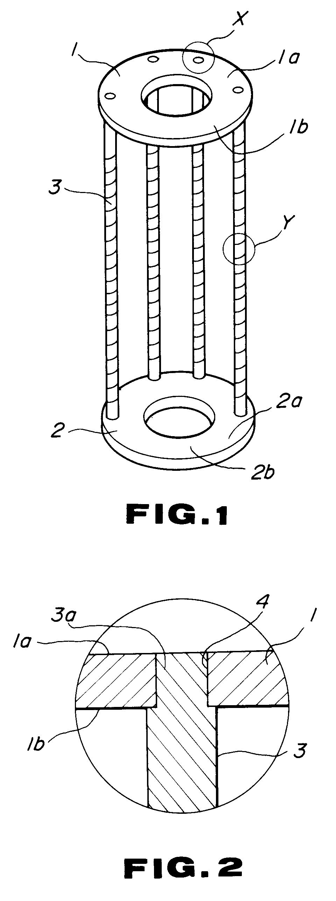

Referring to FIG. 1, there is illustrated one exemplary silicon carbide jig according to the present invention. The jig includes a pair of annular disks 1 and 2 and rods 3 extending between the opposed disks 1 and 2. All these members have been ground on the surface as described above. It is preferred for strength that the members are ground over their entire surface. However, silicon carbide is rather difficult to grind and thus expensive to grind, causing an increase in manufacturing cost. Therefore, it is advantageous for practical applications to grind only the major surfaces 1a and 1b of paired disks 1 and 2 and the circumferential surface of rods 3 where thermal stresses are readily induced to cause failure.

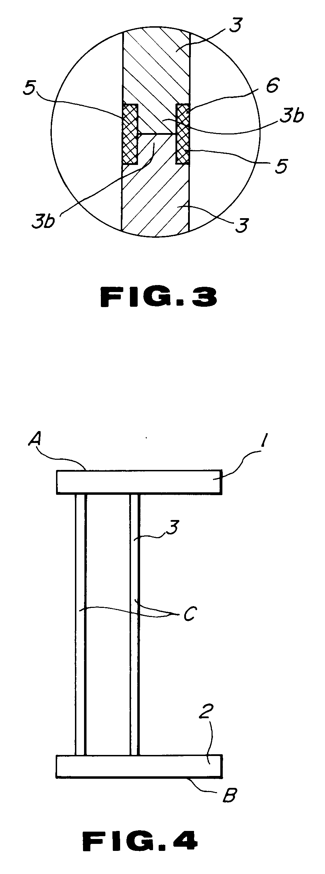

Where rods and plates are fixedly connected, they are preferably finished to an order of microns so that the jig may have high dimensional precision. A rod is connected to a plate through a tongue and groove fit, for example, as shown in FIG. 2, by forming a hole 4 in the plate 1, providing the rod 3 with a reduced dimameter tip portion 3a having substantially the same diameter as the diameter of the hole 4, and inserting the rod tip portion 3a coated with the binder into the plate hole 4 to adhere the rod tip portion 3a and the plate hole 4. Rods are connected together through an abutment joint, for example, as shown in FIG. 3, by circumferentially cutting out end portions 3b of rods 3 at 5 and abutting the end portions 3b, 3b coated with the binder against each other with an annular connector sleeve 6 fitted thereover to adhere the end portions 3b, 3b and the sleeve 6. The joint between members is not limited to these examples.

The silicon carbide jig of the invention generally has a basic structure having rods and plates combined. On actual use, suitable retainers, supports and the like are added to the basic structure, in which case such additional members are also ground on the necessary surfaces to reinforce thermal stress occurring areas. Machining or mechanical grinding as contemplated herein is applicable to not only silicon carbide jigs of a structure as shown in FIG. 1, but also to jigs of a cylindrical structure or vertically segmented ones thereof.

EXAMPLE

Examples of the present invention are given below by way of illustration and not by way of limitation.

Example 1

Using a plane grinder and a cylindrical grinder, disks 1 and 2, rods 3, and connector sleeves 6 of high purity silicon carbide configured as shown in FIG. 1 were ground on their surface. The grinding wheels used were #120 diamond wheels. The ground members had a maximum surface roughness Rmax of 12 $\mu$m.

A binder (phenol resin) was applied to connecting portions of the ground members, which were assembled as shown in FIGS. 1 to 3. The assembly was placed in an furnace where it was heated to 1,500°C to complete joints.

The thus completed jig was tested for dimensional precision by measuring the parallelism between planes A and B and the squareness between plane A and axis C as shown in FIG. 4. The results are shown in Table 1.

Next, the jig was subject to a thermal shock test. The test involved cycles of inserting the jig into a furnace, heating the jig to a predetermined temperature in the ambient atmosphere, holding the temperature for 15 minutes, and thereafter dipping the jig into water. Heating was started from 100°C. On every heating cycle, the maximum heating temperature was measured by an increment of 10°C and the jig was repeatedly dipped into cool water (23°C). The heating temperature was increased until the jig failed upon water immersion. Failure occurred at a total heating temperature increment $\Delta T = 260$°C, that is, when the jig was heated to a temperature of 360°C and dipped in water.

Comparative Example 1

For comparison purposes, a jig was fabricated in accordance with a conventional method. Pre-sintered silicon carbide members of general rod and disk shapes were assembled and jointed as shown in FIG. 1.

The assembly was placed in a sintering furnace where it was sintered at 1,450°C. The sintered assembly was then finished by sand blasting with #60 sand blast abrasives. The surface roughness was measured to find Rmax = 20 μm. The thus completed jig was examined for dimensional precision as in Example 1. The results are shown in Table 1. The jig was also subject to a thermal shock test as in Example 1. It failed at ΔT = 140°C.

Table 1

|  | Planes A-B parallelism | Squareness between plane A and axis C |
|---|---|---|
| Example 1 | 0.07 mm | 0.09 to 0.12 mm |
| Comparison | 0.3 mm | 3.37 to 3.71 mm |

There has been described a silicon carbide jig which is finished to high dimensional precision and free from failure by thermal stresses and shocks. The jig is a useful jig for semiconductor diffusion furnaces.

Although some preferred embodiments have been described, many modifications and variations may be made thereto in the light of the above teachings. It is therefore to be understood that within the scope of the appended claims, the invention may be practiced otherwise than as specifically described.

**Claims**

1. A silicon carbide jig comprising a plurality of sintered silicon carbide members having a machined surface, the members being assembled and jointed into the jig.

2. The jig of claim 1 wherein said members are of bar and/or plate shape.

3. The jig of calim 1 wherein said members are machined by a grinding machine using an abrasive wheel having a grain size of #60 or finer to such a degree that the maximum surface roughness Rmax is up to 15 μm.

4. A method of preparing a silicon carbide jig comprising
   machining the surface of a plurality of sintered silicon carbide members, and
   assembling and jointing the members into the jig.

5. The method of claim 1 wherein said members are of bar and/or plate shapes.

6. The method of claim 1 wherein said members are machined by a grinding machine using an abrasive wheel having a grain size of #60 or finer to such a degree that the maximum surface roughness Rmax is up to 15 μm.

**FIG.1**

**FIG.2**

# FIG.3

# FIG.4

# EUROPEAN SEARCH REPORT

European Patent Office

Application Number

| | DOCUMENTS CONSIDERED TO BE RELEVANT | | EP 92105225.4 |
|---|---|---|---|

| Category | Citation of document with indication, where appropriate, of relevant passages | Relevant to claim | CLASSIFICATION OF THE APPLICATION (Int. Cl. 5) |
|---|---|---|---|
| D,A | PATENT ABSTRACTS OF JAPAN, unexamined applications, E section, vol. 13, no. 5, January 9, 1989 THE PATENT OFFICE JAPANESE GOVERNMENT page 90 E 701 * Kokai-no. 63-217 622 (TOSHIBA CERAMICS) * -- | 1,2,5 | H 01 L 21/22 C 01 B 31/36 |
| A | PATENT ABSTRACTS OF JAPAN, unexamined applications, E section, vol. 13, no. 26, January 20, 1989 THE PATENT OFFICE JAPANESE GOVERNMENT page 12 E 706 * Kokai-no. 63-228 611 (FUJITSU) * -- | 1,3 | |
| A | PATENT ABSTRACTS OF JAPAN, unexamined applications, C section, vol. 14, no. 68, February 8, 1990 THE PATENT OFFICE JAPANESE GOVERNMENT page 104 C 686 * Kokai-no. 1-290 521 (HITACHI CHEM.) * ---- | 1,3 | TECHNICAL FIELDS SEARCHED (Int. Cl.5) H 01 L 21/00 C 01 B 31/00 |

The present search report has been drawn up for all claims

| Place of search | Date of completion of the search | Examiner |
|---|---|---|
| VIENNA | 01-07-1992 | HOFBAUER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)